Europäisches Patentamt

European Patent Office

Office européen des brevets

(19)

(11) Numéro de publication: **0 254 640 B1**

## FASCICULE DE BREVET EUROPEEN

(12)

(45) Date de publication de fascicule du brevet:
09.10.91

(51) Int. Cl.⁵: **G06K 19/06**

(21) Numéro de dépôt: **87401697.5**

(22) Date de dépôt: **21.07.87**

(54) **Procédé de réalisation d'une carte à mémoire électronique et carte telle qu'obtenue par ce procédé.**

(30) Priorité: **24.07.86 FR 8610753**

(43) Date de publication de la demande:
**27.01.88 Bulletin 88/04**

(45) Mention de la délivrance du brevet:
**09.10.91 Bulletin 91/41**

(84) Etats contractants désignés:
**BE CH DE ES FR GB IT LI NL SE**

(56) Documents cités:
**FR-A- 2 439 438**

**PATENT ABSTRACTS OF JAPAN, vol. 10, no. 162 (P-466)[2218], 10 juin 1986; & JP-A-61 15 289 (MITSUBISHI JUSHI K.K.) 23-01-1986**

(73) Titulaire: **SCHLUMBERGER INDUSTRIES, SA**
**12, Place des Etats Unis**
**F-92120 Montrouge(FR)**

(72) Inventeur: **Rebjock, Alain**
**28, Chemin des Bourgognes**
**F-95000 Cergy(FR)**

(74) Mandataire: **Hasenrader, Hubert et al**
**Cabinet BEAU DE LOMENIE 55, rue d'Amsterdam**
**F-75008 Paris(FR)**

Rank Xerox (UK) Business Services

## Description

La présente invention a pour objet un procédé de réalisation de carte électronique et des cartes à mémoire électronique telles qu'obtenues par la mise en oeuvre de ce procédé.

Les cartes à mémoire électronique permettant à leur titulaire d'effectuer un certain nombre de transactions sont maintenant bien connues. Elles peuvent appartenir à deux grandes catégories. Certaines cartes ont un circuit électronique suffisamment élaboré pour permettre de recharger des valeurs fiduciaires dans la mémoire de la carte. En d'autres termes, lorsque la valeur fiduciaire initiale de la carte est épuisée, l'utilisateur moyennant un nouveau paiement, peut faire recharger sa carte à une nouvelle valeur fiduciaire. Un deuxième type de carte dite pré-payée contient un circuit électronique plus simple et la carte est chargée une fois pour toute à une valeur fiduciaire donnée. Lorsque cette valeur a été épuisée par l'utilisateur le carte est à jeter.

Dans le cas des cartes pré-payées qui, donc, ne serviront qu'une fois, on comprend qu'il est nécessaire que le coût de fabrication de la carte soit aussi réduit que possible afin que ce coût ne soit pas prohibitif par rapport à la valeur fiduciaire nécessairement réduite stockée dans la mémoire de la carte. Cela est obtenu en partie du fait que le circuit électronique lui-même est sensiblement moins onéreux que celui qu'on trouve dans une carte rechargeable. Cependant, la fabrication de la carte elle-même intervient de façon aussi non négligeable dans le prix final de la carte. On sait que la carte se compose essentiellement d'un corps en matière plastique dans lequel est logé un module électronique comportant le circuit intégré, les plages de contact pour assurer la connexion avec le lecteur de carte et des connexions électriques entre le circuit intégré et les plages de contact. La fixation du module électronique dans le corps de la carte doit être suffisamment efficace pour que l'ensemble ainsi obtenu satisfasse aux tests de flexion auxquels la carte est soumise. En outre, l'épaisseur de la carte est standardisée et cette épaisseur est de l'ordre du millimètre. On comprend que cette épaisseur réduite rend plus délicates encore l'implantation et la fixation du module électronique dans la carte.

En général le module électronique est réalisé à l'aide d'une technique de circuit imprimé. Plus précisément, le module électronique comporte un support isolant sur lequel on forme des pistes conductrices qui assurent partiellement des connexions électriques entre des plages de contact également formées sur le support isolant et les bornes de la pastille semi-conductrice. On fixe la pastille semi-conductrice sur une des faces du substrat isolant et on réalise l'interconnection entre ses bornes et les pistes conductrices, par exemple à l'aide de fils conducteurs. Cette technique présente l'inconvénient que la réalisation des circuits imprimés est relativement onéreuse si l'on veut que ce circuit imprimé présente des dimensions réduites avec une haute densité de pistes conductrices.

Un tel module électronique est décrit dans le demande de brevet FR-A-2.439.438.

Pour remédier à cet inconvéient un objet de l'invention est de fournir un procédé de réalisation de cartes à mémoire électronique qui ne fasse pas appel aux techniques de circuits imprimés pour la réalisation du module électronique.

Pour atteindre ce but, l'invention utilise pour la réalisation du module électronique la technique dite du cadre conducteur (en anglais lead frame) au lieu de la technique du circuit imprimé.

Le procédé de réalisation d'une carte à mémoire électronique selon l'invention comporte les étapes suivantes:
on fournit un module électronique comprenant un ensemble plan de conducteurs électriques présentant une première et une deuxième face et une pastille semi-conductrice fixée directement sur la première face de l'ensemble plan de conducteurs ;
on fournit un corps de carte présentant une première et une deuxième face dans lequel est ménagé un logement débouchant dans ladite première face et apte à recevoir ledit module électronique ;
on place ledit module électronique dans ledit logement pour que ladite deuxième face dudit module électronique soit sensiblement au même niveau que la première face dudit corps de carte :
on fixe ledit module électronique audit corps de carte; et se caractérise en ce que l'ensemble de conducteurs électriques forme un cadre conducteur dépourvu de support isolant pour définir des plages de contact externes pour ladite carte et des connexions électriques.

Selon un mode préféré de mise en oeuvre, le procédé pour réaliser une carte à mémoire électronique comporte les étapes suivantes :
on fournit un module electronique comprenant un ensemble plan de conducteurs électriques présentant une première et une deuxième face munies d'au moins un trou de fixation, et une pastille semi-conductrice fixée sur la première face de l'ensemble plan de conducteurs ;
on fournit un corps de carte présentant une première et une deuxième face dans lequel sont ménagés un premier évidement débouchant dans la première face du corps de carte pour recevoir l'ensemble plan de conducteurs, un deuxième évidement débouchant dans le fond du premier évidement pour recevoir la pastille semi-conductrice et de picots de fixation faisant saillie hors du premier évidement en relation spatiale avec les trous de fixation ;

on place l'ensemble plan de conducteurs dans le premier évidement pour que les picots pénètrent dans les trous de fixation et que la pastille semi-conductrice pénètre dans le second évidement ;

on écrase les têtes des picots pour assurer une première fixation du module électronique sur le corps de carte et un positionnement de celui-ci ; et

on introduit de la colle dans ledit deuxième évidement et on fait prendre cette colle pour assurer la fixation définitive du module électronique.

On comprend que, selon ce mode de mise en oeuvre du procédé de l'invention, l'ensemble plan de conducteurs électriques forme ce qui a été appelé le cadre conducteur. On comprend également que l'écrasement des têtes de picots assure, dans un premier temps, seulement le positionnement du module électronique par rapport au corps de la carte et une fixation temporaire. La fixation définitive est obtenue en remplissant sensiblement l'évidement à l'aide de la colle, ce qui réalise non seulement la solidarisation définitive mais également le renforcement mécanique du module électronique dans le corps de la carte.

De préférence le deuxième évidement comprend une cavité centrale pour recevoir la pastille semi-conductrice et une pluralité de cavités annexes qui communiquent avec la cavité centrale et qui débouchent dans la première cavité, les cavités annexes ayant une profondeur dans le sens de l'épaisseur du corps de la carte inférieure à celle de la cavité centrale.

On comprend ainsi que, lors de l'introduction de la colle celle-ci pénètre également par capillarité dans les cavités annexes entre le corps de la carte et l'ensemble plan de conducteurs ce qui assure non seulement la fixation du module électronique, mais également le renforcement mécanique du cadre conducteur.

De préférence encore, l'ensemble plan de conducteurs est constitué par une plaque métallique munie de fentes pour séparer les conducteurs métalliques les uns des autres, les différents conducteurs étant mécaniquement reliés entre eux par des ponts. Après la fixation du module électronique sur le corps de la carte ces ponts sont coupés pour obtenir la configuration souhaitée de conducteurs.

De préférence encore la zone des conducteurs métalliques entourant les trous de fixation est emboutie pour former une zone évasée faisant sallie dans la première face de l'ensemble plan de conducteurs et chaque picot est entouré par une gorge dans laquelle pénètre la zone évasée de l'ensemble plan de conducteur. L'extrémité écrasée des picots est sensiblement entièrement logée dans la zone évasée.

L'invention concerne également un module électronique pour carte à mémoire électronique caractérisé en ce qu'il comprend :

un ensemble sensiblement plan de conducteurs électriques formant un cadre conducteur dépourvu de support isolant pour former les plages de contact du module électronique et des zones de connexion ;

une pastille semi-conductrice directement fixée sur une des faces dudit ensemble de conducteurs électroniques ; et

des moyens de connexion électriques entre les bornes de ladite pastille semi-conductrice et lesdits conducteurs électriques.

L'invention concerne encore une carte à mémoire électronique comprenant :

un module électronique tel que défini précédemment ;

un corps de carte muni d'un logement débouchant dans au moins une des deux faces du corps de carte pour y recevoir ledit module électronique de telle manière que la partie desdits conducteurs électriques formant les plages de contact soit sensiblement dans le même plan que ladite face du corps de carte ; et

des moyens pour solidariser ledit module électronique avec ledit corps de carte.

D'autres caractéristiques et avantages de l'invention apparaîtront plus clairement à la lecture de la description qui suit de plusieurs modes de mise en oeuvre de l'invention donnés à titre d'exemples non limitatifs. La description se réfère au dessin annexé sur lequel :

- la figure 1 est une vue de dessus d'un cadre conducteur, selon un premier mode de mise en oeuvre de l'invention ;
- les figures 2a à 2c sont des demi-vues en coupe verticale montrant les étapes de réalisation du module électronique comportant le cadre conducteur représenté sur la figure 1 ;
- la figure 3 est une vue partielle de dessus du corps de la carte montrant la forme des évidements réalisés dans celui-ci, selon le premier mode de mise en oeuvre de l'invention ;
- les figures 4a à 4d sont des demi-vues en coupe verticale qui illustrent les différentes étapes de la fixation du module électronique sur le corps de la carte, selon le premier mode de mise en oeuvre de l'invention ;
- la figure 5 montre en vue partielle de dessus, le module électronique et le corps de la carte à la fin de l'étape déjà illustrée par la figure 4c ;
- les figures 6a à 6c montrent, en demi-vue en coupe verticale, les étapes de réalisation du module électronique selon un deuxième mode de mise en oeuvre de l'invention ;
- la figure 6d est une vue de dessus correspondant à la figure 6c ;

- les figures 7a à 7c montrent, en demi-vue et en coupe verticale, les étapes de réalisation du module électronique selon un troisième mode de mise en oeuvre de l'invention ; et
- les figures 8a à 8c sont des demi-vue en coupe verticale qui illustrent un quatrième mode de mise en oeuvre de l'invention.

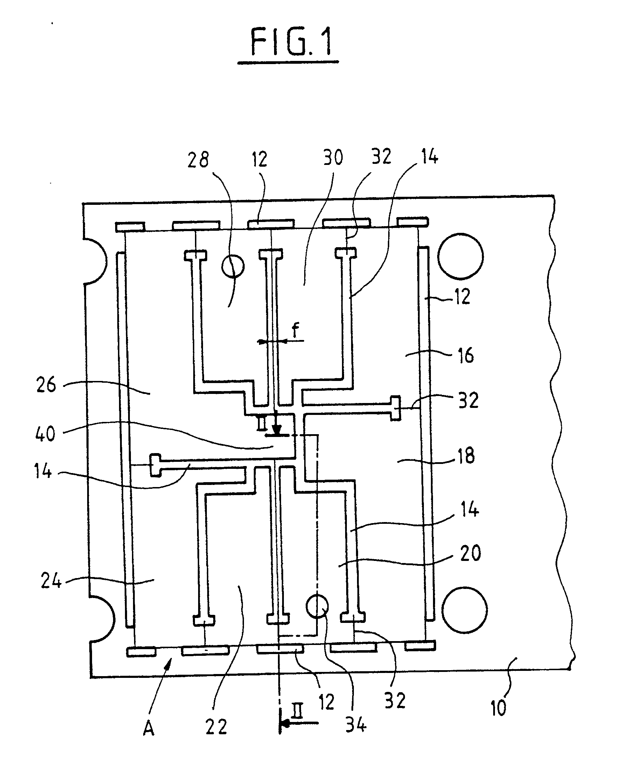

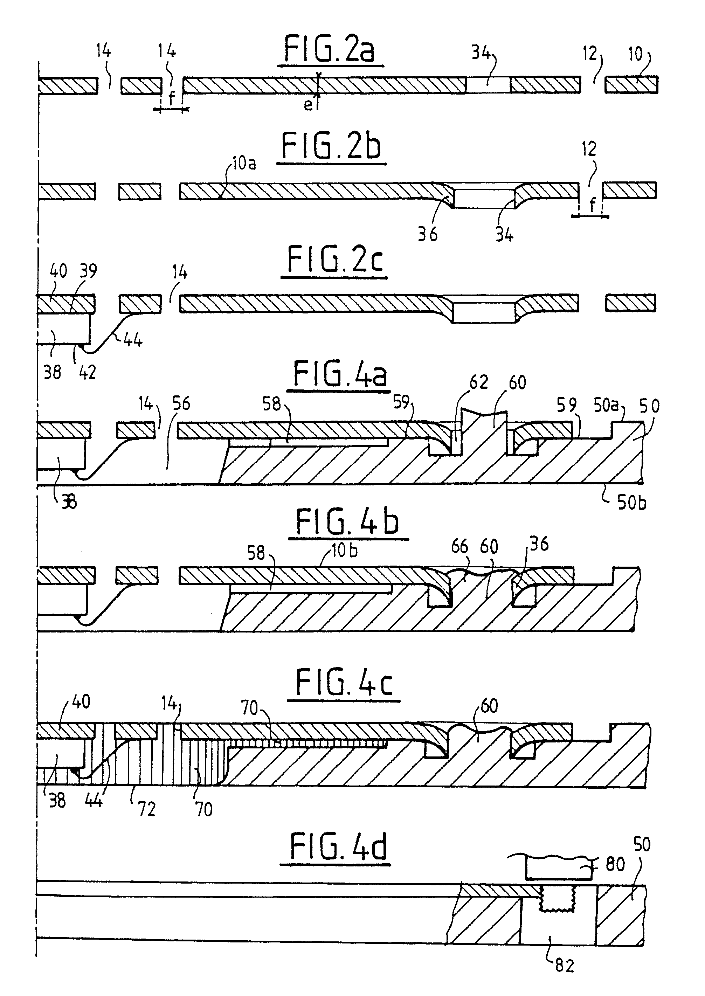

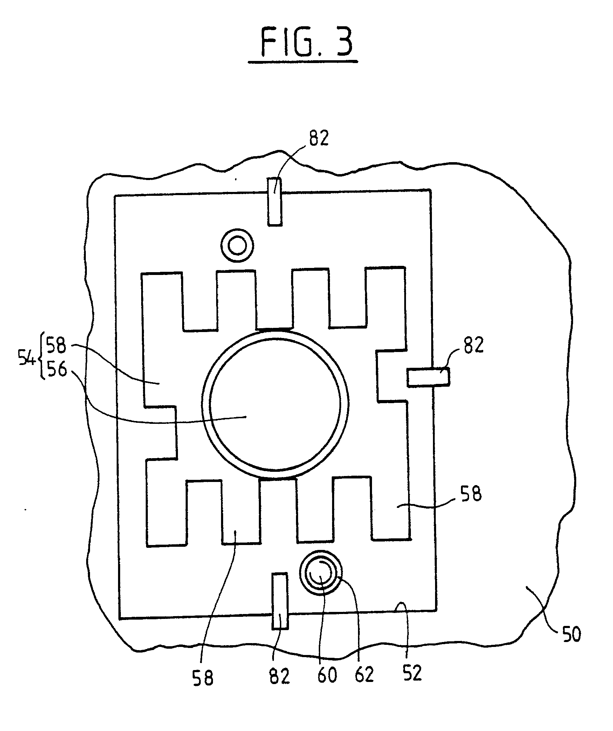

En se référant tout d'abord aux figures 1, 2a, 2b et 2c, on va décrire un premier mode de réalisation du module électronique. Plus précisément la figure 1 et la figure 2a montrent la première étape de la réalisation du cadre conducteur on "lead frame" du module électronique. De préférence, le cadre conducteur est réalisé dans une bande en matériau métallique conducteur 10. Sur une même bande on peut réaliser une pluralité de cadres conducteurs. Un seul cadre référencé A étant représenté sur la figure 1. La portion de la bande 10 correspondant à la partie utile du cadre conducteur est limitée par des fentes de pré-découpage telles que 12. Dans le cas particulier de la figure 1 les fentes de pré-découpage 12 définissent une surface rectangulaire. A l'intérieur de cette surface, la bande métallique 10 est percée de fentes telles que 14 qui séparent ainsi les unes des autres différentes zones conductrices destinées à former les liaisons électriques et les plages de contact que l'on veut réaliser. Sur la figure 1 les fentes 14 définissent huit zones de connexion et de plage de contact référencées 16 à 30. Pour assurer l'intégrité mécanique de cet ensemble, les fentes 14 ne sont pas prolongées jusqu'aux fentes 12 de pré-découpage, mais on laisse subsister des ponts d'interconnexion tels que 32. Le cadre conducteur A comporte de plus des trous de fixation 34 disposés au voisinage des extrémités des zones conductrices. Sur la figure 1, on a représenté seulement les trous 34 ménagés dans les zones conductrices 20 et 28, pour ne pas surcharger la figure. De préférence, il y en a dix.

Dans l'exemple décrit la bande métallique 10 a une épaisseur e égale à 2/10ème de millimètre, ce qui assure une résistance mécanique suffisante. Elle est réalisée par exemple à l'aide d'un alliage cuivre-fer dont le coefficient de dilatation thermique est très proche de celui du silicium. Les fentes telles que 14 ont une largeur f aussi réduite que possible pour des raisons que l'on expliquera ultérieurement. Une largeur f égale à 3/10ème de millimètre permet d'obtenir une isolation électrique entre deux zones conductrices adjacente qui est suffisante. Les trous 34 de fixation ont un diamètre de 6/10ème de millimètre. De préférence les fentes 12 et les trous de fixation 34 sont obtenus par gravure chimique d'une bande métallique pleine.

Comme le montre mieux la figure 2b, dans l'étape suivante, on réalise un emboutissage de la zone de la bande conductrice 10 qui entoure chaque trou de fixation 34. On obtient ainsi des zones évasées 36 qui font saillie hors de la face inférieure 10a de la bande métallique 10. Après cet emboutissage, le diamètre du trou de fixation 34 est porté à environ 0,8 mm.

Dans l'étape suivante, illustrée par la figure 2c, on fixe une pastille semi-conductrice 38 sur la face inférieure 10a de la bande métallique. Plus précisément, la pastille semi-conductrice 38 est fixée à l'extrémité 40 de la zone conductrice 26. La pastille semi-conductrice 38 est fixée par son fond 39 sur la zone conductrice 40 à l'aide d'une colle électriquement conductrice. Cette liaison électrique peut également être réalisée par formation d'un eutectique. Ce dernier mode de liaison peut être utilisé grâce au fait que le matériau formant la bande 10 peut supporter sans dommage la température qu'il faut mettre en oeuvre pour réaliser l'eutectique. Une telle solution est impraticable lorsque le module électronique est réalisé à partir d'un circuit imprimé. Enfin, les bornes telles que 42 de la pastille semi-conductrice 38 sont reliées aux zones conductrices convenables 16 à 30 à l'aide de fils conducteurs 44. On obtient ainsi le module électronique complet qui est encore solidarisé avec le reste de la bande 10.

En se référant aux figures 3 et 4a on va d'abord définir la forme particulière donnée à la partie du corps de la carte dans laquelle on réalise l'implantation du module électronique.

Le corps de la carte qui est référencé 50 a une épaisseur de 0,83 mm entre sa face supérieure 50a destinée à recevoir les plages de connexions et son fond 50b. Le corps de la carte présente un premier évidement 52 qui débouche dans la face supérieure 50a du corps de carte. L'évidement 52 a une profondeur de 0,2 mm ou plus généralement une profondeur égale à l'épaisseur e des conducteurs métalliques du module électronique. L'évidement 52, de forme générale rectangulaire a des dimensions qui sont un peu supérieures aux dimensions externes du cadre conducteur A du module électronique de telle manière que celui-ci puisse y être logé totalement. Le corps de la carte comporte également un deuxième évidement 54 constitué par une cavité centrale de forme cylindrique 56 et par huit cavités annexes 58. La cavité centrale 56 débouche dans le fond 59 du premier évidement 52 et dans le fond 50b du corps de carte. Les cavités annexes 58 débouchent également dans le fond 59 du premier évidement 52 et communiquent avec la cavité centrale 56. Les évidements annexes 58 ont une profondeur de 0,1 mm par rapport au fond 59 du premier évidement. Comme on le voit en comparant les figures 1 et 3, les évidements annexes 58 s'étendent en dessous d'une portion de chacune des zones conductrices 16 à 30 du cadre conducteur A.

Dans le corps 50 de carte, on ménage également des picots de fixation 60 qui font saillie hors du fond 59 du premier évidement 52. Chaque picot 60 est entouré par une gorge annulaire 62 ménagée dans le fond 59 du premier évidement 52.

A titre d'exemple, le picot de fixation 60 a un diamètre de 0,6 mm, c'est-à-dire légèrement inférieur au diamètre du trou de fixation 34 ménagé dans le module électronique. La gorge 62 a une profondeur suffisante pour permettre le logement de la partie évasée 36 de la zone conductrice du module électronique.

Le nombre de picots de fixation 60 est égal au nombre de trous de fixation 34 ménagés dans le cadre conducteur A.

Le module électronique constitué comme on l'a déjà expliqué en liaison avec les figures 1 et 2 est séparé du reste de la bande métallique 10 selon les fentes de pré-découpage 12. Les zones conductrices 16 à 30 restent solidaires les unes des autres grâce à la présence des ponts de liaison 32. Le module électronique est placé sur le corps de carte 50 de telle manière que les picots 60 pénètrent à l'intérieur des trous de fixation 34 et que la face inférieure 10a des conducteurs plan du module électronique repose sur le fond 59 du premier évidement 52. De cette manière, l'ensemble des conducteurs se trouve logés dans le premier évidement 52 et la pastille en matériau semi-conducteur 38 est logée dans la cavité centrale 56. En outre, la face supérieure 10b du module électronique affleure la face supérieure 50a du corps de la carte.

Après cette mise en place du module électronique, on procède à la fixation provisoire de celui-ci sur le corps 50 de la carte. C'est ce qui est illustré par la figure 4b. Pour cela on écrase la tête des picots 60, par exemple, à l'aide d'un outil à ultra-sons. Grâce à la forme évasée de la zone 36 entourant les trous de fixation 34 la tête écrasée 66 de chaque picot de fixation est entièrement logée dans la zone tronconique ainsi définie. En d'autres termes, la partie supérieure de la tête 66 des picots affleure la face supérieure 10b du module électronique.

Dans un deuxième temps, illustré par la figure 4c, on procède au collage définitif du module électronique sur le corps 50 de la carte. Pour cela, on retourne la carte avec son module électronique et on remplit de colle électriquement isolante 70 la cavité centrale 56. Par capillarité, la colle pénètre également dans les cavités annexes 58 qui sont limitées par la présence du module électronique. En revanche, les fentes telles que 14 qui existent dans la plaque métallique sont suffisamment étroites pour que la colle, en raison de la tension superficielle, ne fasse pas saillie hors de la face supérieure 10b des conducteurs métalliques. On provoque ensuite la polymérisation de la colle puis on procède à l'usinage de la face 72 du dépôt de colle 70.

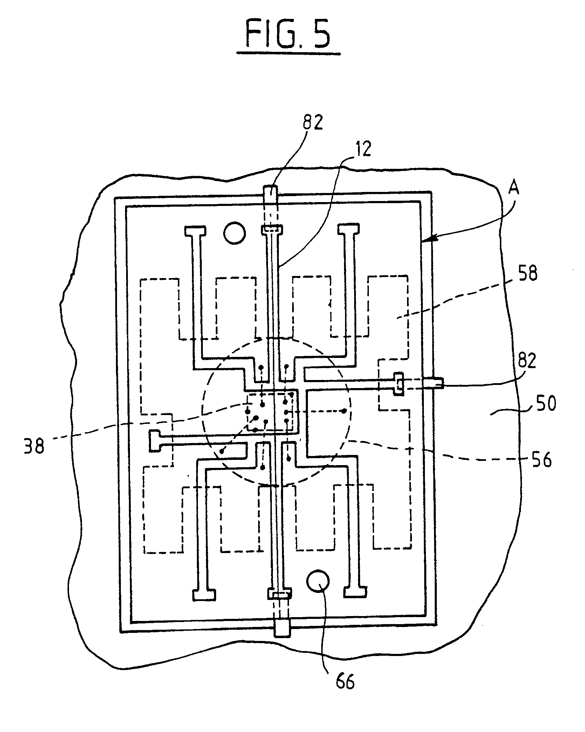

La figure 5 représente en vue de dessus la partie de la carte dans laquelle a été monté le module électronique. Elle montre en particulier la disposition des zones conductrices 16 à 30 qui sont au même niveau que la face supérieure du corps de la carte. Chaque zone conductrice forme une des plages de contract électrique de la carte. La zone 26 sur laquelle est directement fixée la pastille semi-conductrice 38 constitue le contact de masse. Pour terminer la réalisation de la carte, il suffit de procéder à la suppression des ponts d'interconnexion tels que 32. Cela peut être effectué à l'aide d'un outil de découpe illustré en 80 sur la figure 4d. Cette opération est rendue possible grâce au fait que le corps 50 de la carte est muni de trous tels que 82. Chaque trou 82 est disposé en dessous d'un pont de liaison 32. Sur les figures 3 et 5 on a représenté seulement trois trous 82.

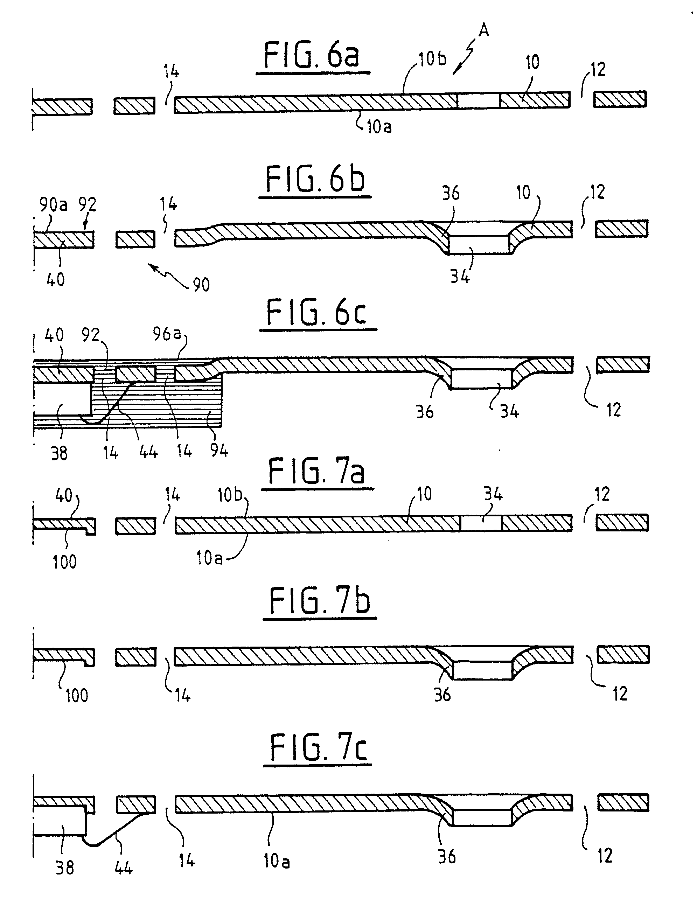

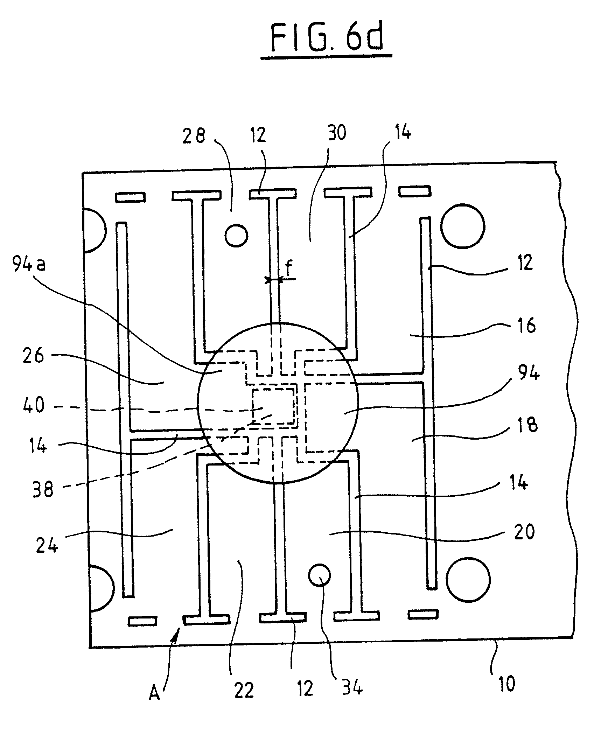

Les figures 6a à 6d illustrent un deuxième mode de réalisation du module électronique.

Selon ce mode de réalisation la portion de la bande 10 servant à réaliser un cadre conducteur A présente des fentes de pré-découpe 12 et des trous de fixation 34 identiques à ceux de la figure 1. La différence réside dans le fait que les fentes 14 qui séparent les zones conductrices 16 à 30 s'étendent jusqu'aux fentes de pré-découpe 12. Cela signifie que les points de liaison 32 de la figure 1 n'existent plus. La figure 6a est donc identique à la figure 2a.

Dans l'étape suivante représentée sur la figure 6b on procède à l'emboutissage des zones de la bande métallique 10 qui entourent les trous de fixation 34 pour former les zones évasées 36 comme dela a déjà été expliqué en liaison avec la figure 2b. Durant cette même étape on provoque, par emboutissage, l'enfoncement de la zone centrale 90 du cadre conducteur A, c'est-à-dire la portion du cadre conducteur qui comprend la zone 40 sur laquelle sera fixée la pastille semi-conductrice, et les extrémités des autres zones conductrices 16 à 24 et 28 et 30. La face supérieure 90a de la zone 90 est donc en retrait par rapport à la face supérieure 10b du reste du cadre conducteur A et forme une cuvette 92.

La figure 6c montre qu'ensuite on fixe la pastille semi-conductrice 38 sur la portion conductrice 40 et on connecte les bornes de la pastille 38 aux zones conductrices convenables à l'aide des fils conducteurs 44. Ensuite on enrobe dans un matériau thermo-durcissable la pastille 38, les fils 44 et la portion enfoncée 90 du cadre conducteur. L'enrobage est référencé 94 sur les figures 6c et 6d. Pour donner une forme extérieure convenable à l'enrobage 94 celui-ci est réalisé par injection dans un moule formé de deux demi-coquilles. Le matériau remplit la cuvette 92, des portions des fentes séparatrices 14 et il entoure la pastille 38 et les fils 44. La face supérieure 94a de l'enrobage est au même niveau que la face supérieure 10b de la partie non enfoncée du cadre conducteur.

Le module électronique ainsi obtenu est séparé du reste de la bande métallique 10, et mis en place et fixé dans le corps de carte 50 exactement comme le module électronique des figures 4a à 4d. Pour cela, il faut que les dimensions extérieures de la partie de l'enrobage 94 entourant la pastille 38 soient inférieures à celle de la cavité centrale 56 du corps de carte 50.

On procède ensuite à l'écrasement des têtes des picots de fixation 60 et au collage définitif du module électronique sur le corps de la carte. L'intérêt de ce mode de mise en oeuvre est que l'étape de la figure 4d est supprimée puisque le cadre conducteur ne comporte pas de points de liaison.

Les figures 7a à 7c illustrent un troisième mode de mise en oeuvre de l'invention et, plus précisément un troisième mode de réalisation du module électronique.

Le cadre conducteur de départ est identique à celui des figures 1 et 2a à la seule différence que sa zone centrale 40 sur laquelle on fixe la pastille semi-conductrice 38 est munie d'une cavité 100 qui débouche dans la face inférieure 10a du cadre conducteur A. La cavité 100 a des dimensions suffisantes pour y permettre un logement partiel de la pastille 38. La cavité 100 peut être obtenue par attaque chimique de la bande conductrice 10 en même temps qu'on réalise les fentes 12 et 14 et les trous de fixation 34. Par exemple on réalise une attaque chimique sur les deux faces de la bande pour obtenir les fentes 12 et 14 et les trous 34 et une attaque sur la seule face 10a pour réaliser la cavité 100. Ensuite le module électronique est découpé du reste de la bande métallique 10 et fixé sur le corps de la carte exactement comme cela a été décrit en liaison avec les figures 4a à 4d.

Ce troisième mode de mise en oeuvre de l'invention permet de réduire l'épaisseur du module électronique. En outre, il peut être combiné au deuxième mode de mise en oeuvre, c'est-à-dire qu'avant de réaliser l'enfoncement de la zone centrale 90 du cadre conducteur (figure 6d), on ménage dans la partie central 40 de celui-ci une cavité identique à celle qui est représentée sur la figure 7a.

Dans les modes de réalisation décrits précédemment, la pré-fixation et le positionnement du module électronique sur le corps de carte sont obtenus par la coopération des picots de fixation faisant partie intégrante du corps de la carte et des trous de fixation ménagés dans le module électronique.

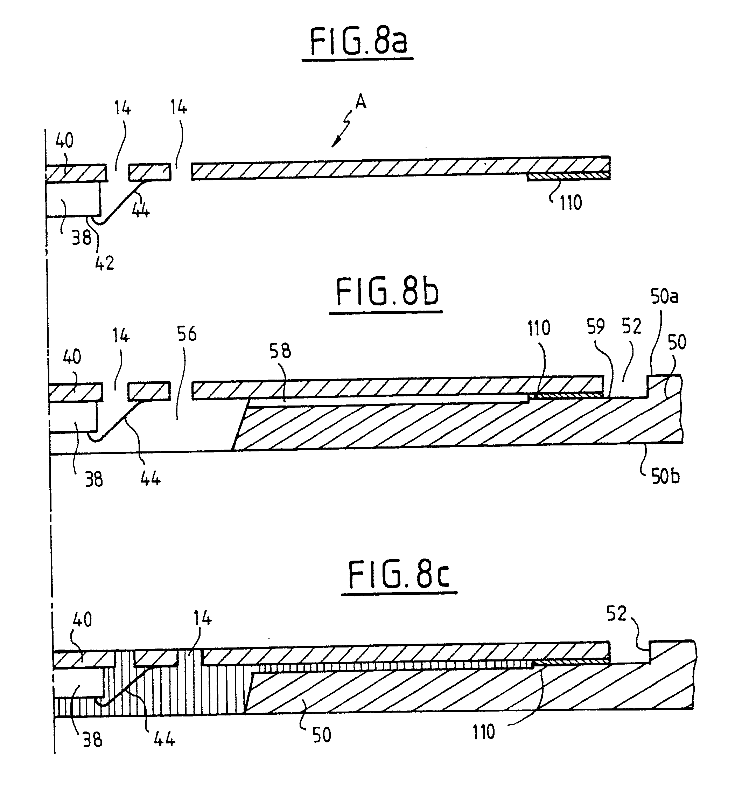

On va décrire maintenant, en se référant aux figures 8a à 8c, un quatrième mode de réalisation de la carte qui met en oeuvre une autre technique de pré-fixation du module électronique.

On part du module électronique représenté sur la figure 8a. Celui-ci est très semblable à celui qui est représenté sur la figure 2c. Il comprend le cadre conducteur A, avec ses fentes 14 séparant les différentes zones conductrices, la pastille semi-conductrice 38 fixée sur la portion conductrice centrale 40, et les fils conducteurs 44 reliant les bornes 42 de la pastille 38 aux zones conductrices convenables du cadre conducteur. Par rapport à la figure 2c, le module électronique ne comporte plus les trous de fixation 34. En revanche, la face inférieure de la périphérie du cadre conducteur est enduite d'une couche mince 110 de matériau adhésif.

Comme le montre la figure 8b, le logement ménagé dans le corps 50 de la carte est également un peu différent de celui qui est montré sur les figures précédentes.

Il comprend l'évidement supérieur 52 destiné à recevoir le cadre conducteur et un évidement inférieur 54 comportant une cavité centrale 56 destinée à recevoir la pastille semi-conductrice 38 et des cavités annexes 58. En revanche, le corps de carte ne comporte ni les picots de fixation 60 ni les gorges annulaires 62 de la figure 4a.

Le module électronique est posé sur le corps de carte de telle manière que le cadre conducteur soit logé dans l'évidement supérieur 52 et la pastille 38 dans la cavité centrale 56, la couche mince 110 de matériau adhésif venant en contact avec le fond 59 de l'évidement supérieur 52. Après polymérisation de la couche de colle, on obtient un positionnement et une préfixation du module électronique sur le corps de la carte.

La figure 8c montre la fixation définitive du module électronique sur le corps de la carte. Cette étape est identique à celle qui a déjà été décrite en liaison avec la figure 4c. Enfin, on procède a la découpe des ponts d'interconnexion comme cela a déjà été expliqué en liaison avec la figure 4d.

Dans la description précédente on a toujours envisagé le cas où la cavité centrale 56 destinée à recevoir la pastille semi-conductrice débouche dans le fond 50b du corps de carte. L'invention s'applique également au cas où la cavité 56 n'est pas débouchante.

Dans ce cas, on dépose dans le fond de la cavité non débouchante une goutte de colle isolant polymérisable. On procède ensuite à la mise en place du module électronique sur le corps de la carte, et à sa préfixation selon l'une des techniques décrites précédemment. Puis on retourne l'ensemble corps de carte-module électronique, de telle manière que la goutte de colle recouvre complètement la pastille semi-conductrice et ses fils conducteurs, et que de la colle pénètre dans les cavités annexes 58. On procède enfin à la polymérisation de la colle, ce qui assure la liaison définitive entre le corps de carte et le module électronique.

## Revendications

1. Procédé de réalisation d'une carte à mémoire électronique comprenant les étapes suivantes :

   a) on fournit un module électronique comprenant un ensemble sensiblement plan (A) de conducteurs électriques (16 à 30), ledit ensemble présentant une première face (10a) et une deuxième face (10b), et une pastille semi-conductrice (38) directement fixée sur ladite première face ;
   b) on fournit un corps de carte (50) présentant une première (50a) et une deuxième (50b) face principale sensiblement parallèles entre elles, et muni d'un logement (52, 56, 58) débouchant au moins dans ladite première face principale (50a) et apte à recevoir ledit module électronique ;
   c) on place ledit module électronique dans ledit logement (52, 56, 58) pour que ladite deuxième face (10b) du module soit disposée sensiblement dans le même plan que ladite première face principale (50a) du corps de carte ;
   d) on fixe ledit module électronique audit corps de carte;

   le procédé étant caractérisé en ce que l'ensemble de conducteurs électriques (16 à 30) forme un cadre conducteur dépourvu de support isolant pour définir des plages de contact externes pour ladite carte et des connexions électriques.

2. Procédé selon la revendication 1, caractérisé en ce qu'on perce dans ledit ensemble plan (A) de conducteurs des trous de fixation (34) ; en ce que, dans le corps de carte qui est constitué par un matériau plastique on forme de picots de fixation (60), en ce que, dans l'étape c) on place le module électronique pour que lesdits picots pénètrent dans lesdits trous de fixation (34), et en ce que l'étape d) se subdivise en une étape e) dans laquelle on déforme les têtes (66) des picots pour réaliser une pré-fixation dudit module au dit corps de carte et en une étape f) dans laquelle on colle ledit module au dit corps de carte avec une matériau adhésif isolant électrique (70) de telle manière que ledit matériau adhésif remplisse sensiblement la totalité de la partie dudit logement non occupée par ledit module électronique.

3. Procédé selon la revendication 2, caractérisé en ce que, pour fournir ledit ensemble sensiblement plan de conducteurs, on part d'un élément de plaque pleine (A) en un matériau conducteur de l'électricité, on creuse dans ledit élément de plaque des fentes (14) pour séparer les unes des autres des zones conductrices (16 à 30) formant lesdites plages de connexion et lesdites connexion électriques en laissant subsister à la périphérie dudit élément de plaque des ponts de liaison (32) entre lesdites zones conductrices pour maintenir lesdites zones conductrices solidaires entre elles ; et en ce que, après l'étape d), on découpe lesdits ponts de liaison pour isoler électriquement lesdites zones conductrices les unes des autres.

4. Procédé selon l'une quelconque des revendications 2 et 3 caractérisé en ce que ledit logement ménagé dans ledit corps de carte comprend un premier évidement (52) débouchant dans ladite première face principale du corps de carte pour recevoir ledit ensemble sensiblement plan de conducteurs, et un deuxième évidement (54) comprenant une cavité principale (56) débouchant dans le fond (59) dudit premier évidement et dans ladite deuxième face principale du corps de carte, et des cavités annexes (58) débouchant dans le fond dudit premier évidement et dans ladite cavité centrale, ladite cavité centrale étant apte à recevoir ladite pastille semi-conductrice.

5. Procédé selon la revendication 4, caractérisé en ce que, dans l'étape c) on place ledit module électronique dans ledit premier évidement pour que, de plus, ladite première face de l'ensemble sensiblement plan de conducteurs soit sensiblement en contact avec le fond dudit premier évidement, et en ce que dans l'étape f) on introduit ledit matériau adhésif isolant par ladite cavité centrale pour qu'il remplisse sensiblement la totalité de la partie dudit deuxième évidemment non occupée par ledit module électronique.

6. Procédé selon l'une quelconque des revendications 2 à 5, caractérisé en ce que les portions (36) des conducteurs électriques de l'ensemble sensiblement plan qui entourent lesdits trous de fixation sont évasées en faisant saillie dans ladite première face de l'ensemble plan pour que, lors de l'étape e), les têtes déformées desdits picots de fixation soient sensiblement entièrement logées dans la zone évasée ainsi limitée.

7. Procédé selon la revendication 1, caractérisé en ce que ledit logement ménagé dans ledit corps de carte comprend un premier évidement (52) débouchant dans ladite première face principale du corps de carte pour recevoir ledit ensemble sensiblement plan de conducteurs, et un deuxième évidement (54) comprenant une cavité principale (56) débouchant dans le fond (59) dudit premier évidement et dans ladite deuxième face principale du corps de carte, et des cavités annexes (58) débouchant dans le fond dudit premier évidement et dans ladite cavité centrale, ladite cavité centrale étant apte à recevoir ladite pastille semi-conductrice, et en ce quel'étape d) se subdivise en une étape h) dans laquelle on colle la périphérie dudit ensemble sensiblement plan de conducteurs électriques sur le fond dudit premier évidement et en une étape j) dans laquelle on introduit ledit matériau adhésif isolant par ladite cavité centrale pour qu'il remplisse sensiblement la totalité de la partie dudit deuxième évidemment non occupée par ledit module électronique.

8. Procédé selon la revendication 1, caractérisé en ce que, pour réaliser un ensemble sensiblement plan de conducteurs électriques ont part d'une plaque métallique conductrice (10), on définit dans ladite plaque une pluralité de surfaces disjointes, chaque surface étant apte à fournir un ensemble sensiblement plan de conducteurs électriques, on ménage dans chaque surface une pluralité de fentes de séparation (14) pour séparer entre elles des zones conductrices (16 à 30) formant lesdits conducteurs électriques, chaque zone conductrice restant solidaire de la partie de ladite plaque conductrice extérieure à ladite surface ; et on sépare du reste de ladite plaque l'élément de plaque défini par ladite surface.

9. Module électronique pour carte à mémoire électronique caractérisé en ce qu'il comprend un ensemble sensiblement plan (A) de conducteurs électriques (16 à 30) formant un cadre conducteur dépourvu de support isolant pour définir des plages de contact externes pour ladite carte et des connexions électriques, ledit ensemble présentant une première face (10a) et une deuxième (10b) face, une pastille semi-conductrice (38) directement fixée sur ladite première face, et des moyens (44) pour relier électriquement les bornes (42) de ladite pastille aux dits conducteurs électriques.

10. Module électronique selon la revendication 9, caractérisé en ce que ledit ensemble sensiblement plan de conducteurs, est constitué par un élément (A) de plaque (10) en un matériau conducteur dans lequel sont creusées des fentes (14) pour séparer les unes des autres des zones conductrices (16 à 30) formant lesdites connexions électriques et lesdites plages de contact, en laissant subsister à la périphérie dudit élément de plaque des ponts de liaison (32) entre lesdites zones conductrices pour maintenir lesdites zones conductrices solidaires entre elles.

11. Module électronique selon la revendication 10, caractérisé en ce qu'une desdites zones conductrices (26) comporte une extrémité (40) disposée sensiblement au centre dudit élément de plaque, et en ce que la face (39) de ladite pastille semi-conductrice dépourvue de bornes est fixée entièrement sur ladite extrémité de ladite zone conductrice par un moyen de fixation conducteur de l'électricité.

12. Module électronique selon la revendication 9 caractérisé en ce que ledit ensemble sensiblement plan de conducteurs, est constitué par un élément (A) de plaque (10) en un matériau conducteur dans lequel sont creusées des fentes (14) pour séparer les unes des autres des zones conductrices (16 à 30) formant lesdites connexions électriques et lesdites plages de contact, en ce que une desdites zones conductrices (26) comporte une extrémité (40) disposée sensiblement au centre dudit élément de plaque, et en ce que la face (39) de ladite pastille semi-conductrice dépourvue de borne est fixée entièrement sur ladite extrémité de ladite zone conductrice par un moyen de fixation conducteur de l'électricité, et en ce que ladite pastille semi-conductrice et lesdits moyens de liaison électrique sont enrobés dans un matériau adhésif isolant (94).

13. Module électronique selon la revendication 12, caractérisé en ce que la portion centrale (90) dudit élément de plaque incluant ladite extrémité de la zone conductrice sur laquelle est fixée ladite pastille semi-conductrice est en retrait par rapport à ladite deuxième face dudit élément de plaque pour former une cuvette (92), et en ce que ledit matériau adhésif isolant remplit également ladite cuvette et les parties desdites fentes de séparation disposées dans ladite portion centrale.

**14.** Carte à mémoire électronique comprenant un module électronique selon l'une quelconque des revendications 9 à 13 et caractérisée en ce que ladite carte comprend : un corps de carte (50) réalisé en un matériau plastique présentant une première et une deuxième face principale et muni d'un évidement (52, 56, 58) débouchant dans ladite première face principale (50a) : et ledit module électronique étant fixé dans ledit évidement pour que ladite deuxième face (10b) dudit ensemble sensiblement plan de conducteurs (A) soit sensiblement disposée dans le même plan que ladite première face (50a) dudit corps de carte.

**15.** Procédé selon la revendication 1, caractérisé en ce que pour fournir ledit module électronique, on relie électriquement les bornes de ladite pastille aux dits conducteurs électriques, et on réalise un enrobage de la pastille semi-conductrice en plaçant dans un moule la partie de l'ensemble de conducteurs sur laquelle la pastille est fixée en introduisant dans ledit moule un matériau isolant d'enrobage.

## Claims

**1.** Method of realization of an electronic memory card comprising the following steps :

a) an electronic module is provided which comprises an appreciably flat assembly (A) of electrical conductors, the assembly presenting a first (10a) and a second side (10b), and a semiconductor chip (38) attached directly to the first side;
b) a card body (50) is provided with a first (50a) and a second main side (50b) which are appreciably parallel to each other; having a seating (52, 56, 58) which opens out at least into the first main side (50a) and is suitable for accommodating the electronic module;
c) the electronic module is placed in the seating (52, 56, 58) so that the said second side (10b) of the module is positioned appreciably on the same plane as the first main side (50a) of the card body;
d) the electronic module is attached to the card body;

the method being characterized by the fact that the assembly of electrical conductors (16 to 30) forms a conducting frame with no insulating backing so as to define external contact tabs for the card and electrical connections.

**2.** Method in accordance with claim 1, characterized by the fact that attachment holes (34) are drilled in the flat conductor assembly (A); by the fact that attachment lugs (60) are formed in the card body which is made from plastic; by the fact that in step c) the electronic module is positioned so that the lugs penetrate into the attachment holes (34), and the fact that step d) is divided into a step e), in which the heads (66) of the lugs are deformed to obtain a preliminary attachment of the module to the card body, and a step f) in which the module is glued to the card body by an electrically insulating adhesive material (70) so that the adhesive material appreciably fills the whole of the part oil the seating not occupied by the electronic module.

**3.** Method in accordance with claim 2, characterized by the fact that, to provide the appreciably flat conductor assembly, one starts from a solid strip component (A) of a material which conducts electricity, slots (14) are made in the strip component to separate from each other conducting zones (16 to 30) which form the connecting tabs and the electrical connections, allowing connecting bridges (32) to exist between the conducting zones on the periphery of the strip component to maintain the conducting zones joined to each other, and by the fact that, after step d), the connecting bridges are cut to electrically insulate the conducting zones from each other.

**4.** Method in accordance with either of claims 2 or 3 characterized by the fact that the seating made in the card body comprises a first window (52) opening out into the first main side of the card body to accommodate the appreciably flat conductor assembly, and a second window (54) comprising a main cavity (56) opening out into the bottom (59) of the first window and into the second main side of the card body, and associated cavities (58) opening out into the bottom of the first window and into the central cavity, the central cavity being suitable for accommodating the semiconductor chip.

**5.** Method in accordance with claim 4, characterized by the fact that in step c), the electronic module is placed in the first window so that, in addition, the first side of the appreciably flat conductor assembly is appreciably in contact with the bottom of the first window, and by the fact that in step f) the insulating adhesive material is inserted through the central cavity so that it appreciably fills the whole of the part of the second window not occupied by the electronic module.

6. Method in accordance with any of claims 2 to 5, characterized by the fact that the portions (36) of the electrical conductors of the appreciably flat assembly which surround the attachment holes are widened and project into the first side of the flat assembly so that, during step e), the deformed heads of the attachment lugs are appreciably fully seated in the widened area thus delimited.

7. Method in accordance with claim 1, characterized by the fact that the seating in the card body comprises a first window (52) opening out into the first main side of the card body to accommodate the appreciably flat conductor assembly, and a second window (54) comprising a main cavity (56) opening out into the bottom (59) of the first window and into the second main side of the card body, and associated cavities (58) opening out into the bottom of the first window and into the central cavity, with the central cavity being suitable for accommodating the semiconductor chip, and by the fact that step d) is divided into a step h), in which the periphery of the appreciably flat electrical conductor assembly is glued to the bottom of the first window, and a step j) in which the insulating adhesive material is inserted through the central cavity so that it appreciably fills the whole of the part of the second window not occupied by the electronic module.

8. Method in accordance with claim 1, characterized by the fact that, to make an appreciably flat electrical conductor assembly, one starts from a metal conducting strip (10), several unconnected areas are defined in the strip, each area being suitable for providing an appreciably flat assembly of electrical conductors, and on each area several separating slots (14) are made to separate from each other conducting zones (16 to 30) which form the electrical conductors, each conducting zone remaining connected to the part of the conducting strip outside the area; and the strip component defined by the area is separated from the rest of the strip.

9. Electronic module for electronic memory card characterized by the fact that it comprises an appreciably flat assembly (A) of electrical conductors (16 to 30) forming a conducting frame with no insulating backing for defining external contact tabs for the card and also electrical connections, this assembly presenting a first side (10a) and a second side (10b), a semiconductor chip (38) attached directly to the first side and means (44) for electrically connecting the pins (42) of the chip to the electrical conductors.

10. Electronic module in accordance with claim 9, characterized by the fact that the appreciably flat conductor assembly consists of a strip (10) component (A) of a conducting material in which slots (14) are made for separating from each other conducting zones (16 to 30) which form the electrical connections and contact tabs, allowing connecting bridges (32) to exist between the conducting zones in order to maintain the conducting zones joined to each other.

11. Electronic module in accordance with claim 10, characterized by the fact that one of the conducting zones (26) comprises one end (40) situated appreciably at the centre of the strip component, and by the fact that the side (39) of the semiconductor chip with no pins is fully attached to the end of the conducting zone by a means of attachment which conducts electricity.

12. Electronic module in accordance with claim 9, characterized by the fact that the appreciably flat conductor assembly consists of a strip (10) component (A) of a conducting material in which slots (14) are made to separate from each other conducting zones (16 to 30) forming the electrical connections and contact bands, and by the fact that one of the conducting zones (26) comprises one end (40) located appreciably at the centre of the strip component, and by the fact that the side (39) of the semiconducting chip with no pins is fully attached to the conducting zone by a means of attachment which conducts electricity, and by the fact that the semiconductor chip and the means of electrical connection are coated with an insulating adhesive material (94).

13. Electronic module in accordance with claim 12, characterized by the fact that the central portion (90) of the strip component, including the end of the conducting zone on which the semiconductor chip is attached, is recessed in relation to the second side of the strip component to form a bowl (92), and by the fact that the insulating adhesive material also fills the bowl and the parts of the separating slots located in the central portion.

14. Electronic memory card comprising an electronic module in accordance with any of the claims 9 to 13 and characterized by the fact that the card comprises: a card body (50) made of plastic presenting a fist and a second main side and comprising a window (52, 56, 58) opening out into the first main side (50a); and the electronic module being attached in the window so that the second side (10b of the appreciably flat conductor assembly (A) is positioned appreciably on the same plane as the first side (50a) of the card body.

15. Method in accordance with claim 1, characterized by the fact that to provide the electronic module, the pins of the chip are electrically connected to the electrical conductors, and the semiconductor is coated by placing in a mould the part of the conductor assembly on which the chip is attached, and inserting an insulating coating material into the mould.

## Patentansprüche

1. Verfahren zur Herstellung einer elektronischen Speicherkarte, das die folgenden Schritte umfaßt:

    a) Fertigen eines elektronischen Moduls, der eine im wesentlichen ebene Gesamtheit (A) von elektrischen Leitern (16 bis 30) umfaßt, wobei die Gesamtheit eine erste Seite (10a) und eine zweite Seite (10b) und einen an der ersten Seite direkt befestigten Halbleiterchip (38) aufweist;
    b) Fertigen eines Kartenkörpers (50), der eine erste (50a) und eine zweite (50b) Hauptseite, die im wesentlichen zueinander parallel sind, aufweist und mit einem Aufnahmesitz (52, 56, 58) versehen ist, der wenigstens in der ersten Hauptseite (50a) ausgespart ist und zur Aufnahme des elektronischen Moduls geeignet ist;
    c) Anordnen des elektronischen Moduls im Aufnahmesitz (52, 56, 58), derart, daß die zweite Seite (10b) des Moduls im wesentlichen in derselben Ebene wie die erste Hauptseite (50a) des Kartenkörpers angeordnet ist;
    d) Befestigen des elektronischen Moduls am Kartenkörper;

    wobei das Verfahren dadurch gekennzeichnet ist, daß die Gesamtheit der elektrischen Leiter (16 bis 30) einen Leiterrahmen ohne isolierenden Träger bildet, um für die Karte und die elektrischen Verbindungen externe Kontaktbereiche zu definieren.

2. Verfahren gemäß Anspruch 1, dadurch gekennzeichnet, daß die ebene Gesamtheit (A) von Leitern mit Befestigungslöchern (34) durchsetzt wird; daß im Kartenkörper, der aus Kunststoffmaterial besteht, Befestigungsspitzen (60) gebildet werden, daß im Schritt c) der elektronische Modul so angeordnet wird, daß die Spitzen in die Befestigungslöcher (34) eindringen, und daß der Schritt d) in einen Schritt e), in dem die Köpfe (66) der Spitzen verformt werden, um eine Vorbefestigung des Moduls am Kartenkörper zu verwirklichen, und in einen Schritt f), in dem der Modul am Kartenkörper mit einem elektrisch isolierenden Haftmaterial (70) so angeklebt wird, daß das Haftmaterial im wesentlichen den gesamten vom elektronischen Modul nicht belegten Teil des Aufnahmesitzes ausfüllt, unterteilt wird.

3. Verfahren gemäß Anspruch 2, dadurch gekennzeichnet, daß zum Fertigen der im wesentlichen ebenen Leitergesamtheit von einem Massivplattenelement (A) aus einem elektrisch leitenden Material ausgegangen wird, daß in dem Plattenelement Schlitze (14) ausgespart werden, um die leitenden Zonen (16 bis 30), die die Anschlußbereiche und die elektrischen Verbindungen bilden, voneinander zu trennen, wobei an der Umfangsfläche des Plattenelements zwischen den leitenden Zonen Verbindungsbrücken (32) bestehen bleiben, um die leitenden Zonen untereinander verbunden zu halten; und daß nach dem Schritt d) die Verbindungsbrücken durchtrennt werden, um die leitenden Zonen voneinander elektrisch zu isolieren.

4. Verfahren gemäß einem der Ansprüche 2 und 3, dadurch gekennzeichnet, daß der im Kartenkörper ausgesparte Aufnahmesitz eine erste Aussparung (52), die in der ersten Hauptseite des Kartenkörpers ausgespart ist, um die im wesentlichen ebene Leitergesamtheit aufzunehmen, und eine zweite Aussparung (54) mit einer Hauptaustiefung (56), die im Boden (59) der ersten Aussparung und in der zweiten Hauptseite des Kartenkörpers ausgespart ist, und zusätzlichen Austiefungen (58), die im Boden der ersten Aussparung und in der zentralen Austiefung ausgespart sind, aufweist, wobei die zentrale Austiefung dazu geeignet ist, den Halbleiterchip aufzunehmen.

5. Verfahren gemäß Anspruch 4, dadurch gekennzeichnet, daß im Schritt c) der elektronische Modul in der ersten Aussparung angeordnet wird, damit sich außerdem die erste Seite der im wesentlichen ebenen Leitergesamtheit im wesentlichen in Kontakt mit dem Boden der ersten Aussparung befindet, und daß im Schritt f) durch die zentrale Austiefung das isolierende Haftmaterial eingeleitet wird, damit es im wesentlichen die Gesamtheit des nicht vom elektronischem Modul belegten Teils der zweiten Aussparung ausfüllt.

6. Verfahren gemäß einem der Ansprüche 2 bis 5, dadurch gekennzeichnet, daß diejenigen Teile (36) der elektrischen Leiter der im wesentlichen ebenen Gesamtheit, die die Befestigungslöcher umgeben, konisch erweitert werden, indem sie in die erste Seite der ebenen Gesamtheit vorstehen, damit im Schritt e) die verformten Köpfe der Befestigungsspitzen im wesentlichen vollständig von der so begrenzten konisch erweiterten Zone aufgenommen werden.

7. Verfahren gemäß Anspruch 1, dadurch gekennzeichnet, daß der im Kartenkörper ausgesparte Aufnahmesitz eine erste Aussparung (52), die in der ersten Hauptseite des Kartenkörpers ausgespart ist, um die im wesentlichen ebene Gesamtheit von Leitern aufzunehmen, und eine zweite Aussparung (54) mit einer im Boden (59) der ersten Aussparung und in der zweiten Hauptseite des Kartenkörpers ausgesparten Hauptaustiefung (56) und zusätzlichen Austiefungen (58), die im Boden der ersten Aussparung und in der zentralen Austiefung ausgespart sind, umfaßt, wobei die zentrale Austiefung dazu geeignet ist, den Halbleiterchip aufzunehmen, und daß der Schritt d) in einen Schritt h), in dem die Umfangsfläche der im wesentlichen ebenen Gesamtheit der elektrischen Leiter auf den Boden der ersten Aussparung geklebt wird, und einen Schritt j), in dem durch die zentrale Austiefung das isolierende Haftmaterial eingeleitet wird, damit es im wesentlichen den gesamten nicht vom elektronischen Modul belegten Teil der zweiten Aussparung ausfüllt, unterteilt wird.

8. Verfahren gemäß Anspruch 1, dadurch gekennzeichnet, daß zur Herstellung einer im wesentlichen ebenen Gesamtheit von elektrischen Leitern von einer leitenden Metallplatte (10) ausgegangen wird, daß in der Platte eine Mehrzahl von nicht verbundenen Oberflächen definiert werden, wobei jede Oberfläche dazu geeignet ist, eine im wesentlichen ebene Gesamtheit von elektrischen Leitern zu ergeben, daß in jeder Oberfläche eine Mehrzahl von Trennschlitzen (14) ausgespart werden, um leitende Zonen, die die elektrischen Leiter bilden, voneinander zu trennen, wobei jede leitende Zone mit demjenigen Teil der Leiterplatte, die außerhalb der Oberfläche liegt, verbunden bleibt; und daß das von der Oberfläche definierte Plattenelement von der restlichen Platte getrennt wird.

9. Elektronischer Modul für elektronische Speicherkarte, dadurch gekennzeichnet, daß er eine im wesentlichen ebene Gesamtheit (A) von elektrischen Leitern (16 bis 30) umfaßt, die einen Leiterrahmen ohne isolierenden Träger bildet, um für die Karte und die elektrischen Verbindungen externe Kontaktbereiche zu definieren, wobei die Gesamtheit eine erste Seite (10a) und eine zweite (10b) Seite, einen mit der ersten Seite direkt verbundenen Halbleiterchip (38) und Mittel (44) zur elektrischen Verbindung der Anschlüsse (42) des Chips mit den elektrischen Leitern aufweist.

10. Elektronischer Modul gemäß Anspruch 9, dadurch gekennzeichnet, daß die im wesentlichen ebene Gesamtheit von Leitern von einem Plattenelement (10, A) aus einem Leitermaterial gebildet wird, in dem Schlitze (14) ausgespart sind, um die leitenden Zonen (16 bis 30), die die elektrischen Verbindungen und die Kontaktbereiche bilden, voneinander zu trennen, wobei an der Umfangsfläche des Plattenelementes zwischen den leitenden Zonen Verbindungsbrücken bestehen bleiben, um die leitenden Zonen untereinander verbunden zu halten.

11. Elektronischer Modul gemäß Anspruch 10, dadurch gekennzeichnet, daß eine der leitenden Zonen (26) ein im wesentlichen in der Mitte des Plattenelementes angeordnetes Ende (40) aufweist und daß die anschlußlose Seite (39) des Halbleiterchips durch ein elektrisch leitendes Befestigungsmittel an der leitenden Zone vollständig befestigt ist.

12. Elektronischer Modul gemäß Anspruch 9, dadurch gekennzeichnet, daß die im wesentlichen ebene Gesamtheit von Leitern von einem Plattenelement (A, 10) aus einem leitenden Material gebildet wird, in dem Schlitze (14) ausgespart sind, um leitende Zonen (16 bis 30), die die elektrischen Verbindungen und die Kontaktbereiche bilden, voneinander zu trennen, daß eine der leitenden Zonen (26) ein im wesentlichen in der Mitte des Plattenelementes angeordnetes Ende (40) aufweist, daß die anschlußlose Seite (39) des Halbleiterchips durch ein elektrisch leitendes Befestigungsmittel am Ende der leitenden Zone vollständig befestigt ist und daß der Halbleiterchip und die elektrischen Verbindungsmittel in einem isolierenden Haftmaterial (94) eingebettet sind.

13. Elektronischer Modul gemäß Anspruch 12, dadurch gekennzeichnet, daß der zentrale Teil (90) des Plattenelementes, der dasjenige Ende der leitenden Zone, an dem der Halbleiterchip befestigt ist, enthält, in bezug auf die zweite Seite des Plattenelementes zurückversetzt ist, um eine Wanne (92) zu bilden, und daß das isolierende Haftmaterial sowohl die Wanne als auch diejenigen Teile der Trennschlitze, die sich im zentralen Teil befinden, ausfüllt.

14. Elektronische Speicherkarte mit einem elektronischen Modul gemäß einem der Ansprüche 9 bis 13 und da-durch gekennzeichnet, daß die Karte umfaßt: einen Kartenkörper (50), der aus einem Kunststoffmaterial hergestellt ist und eine erste und eine zweite Hauptseite aufweist und mit einer Aussparung (52, 56, 58) versehen ist, die in der ersten Hauptseite (50a) ausgespart ist, wobei der elektronische Modul in der Aussparung befestigt wird, derart, daß die zweite Seite (10b) der im wesentlichen ebenen Gesamtheit (A) von Leitern im wesentlichen in derselben Ebene wie die erste Seite (50a) des Kartenkörpers angeordnet wird.

15. Verfahren gemäß Anspruch 1, dadurch gekennzeichnet, daß zum Fertigen des elektronischen Moduls die Anschlüsse des Chips mit den elektrischen Leitern verbunden werden und eine Einbettung des Halbleiterchips bewerkstelligt wird, indem in einer Gießform derjenige Teil der Gesamtheit von Leitern angeordnet wird, an dem der Chip befestigt ist, und indem in die Gießform ein isolierendes Einbettungsmaterial eingeleitet wird.

# FIG.1

FIG.2a

FIG.2b

FIG.2c

FIG.4a

FIG.4b

FIG.4c

FIG.4d

# FIG. 3

# FIG. 5

## FIG. 6a

14  10b  A  10  12
10a

## FIG. 6b

90a 92  14  36  10  12
40  90  34

## FIG. 6c

40  92  96a
38  14  44  14  94  36  34  12

## FIG. 7a

40  14  10b  10  34  12
100  10a

## FIG. 7b

100  14  36  12

## FIG. 7c

38  44  14  10a  36  12

18

# FIG. 6d

## FIG.8a

## FIG.8b

## FIG.8c